# EUROPÄISCHE PATENTANMELDUNG

(11) **EP 4 808 319 A1**
(43) Veröffentlichungstag der Anmeldung: **16.09.2026**
(21) Anmeldenummer: 25163580.1
(22) Anmeldetag: 13.03.2025
(51) Int. Cl.: H10H 29/49, H01R 4/2404, H01R 4/58

(54) **VORRICHTUNG ZUR BILDDARSTELLUNG**

(71) Anmelder: TFFI GmbH & Co KG, 1010 Wien (AT)
(72) Erfinder: MAYER, Sebastian, 1090 Wien (AT)
(74) Vertreter: SONN Patentanwälte GmbH & Co KG

(57) **Zusammenfassung**

Vorrichtung (1) zur Bilddarstellung aufweisend:
einen eine Oberseite (2), eine Unterseite (3), eine erste elektrisch leitfähige Schicht (8), eine zweite elektrisch leitfähige Schicht (9) und zumindest eine lichtleitende Schicht (10) aufweisenden, Ansteuereinheiten (5) und ansteuerbare Leuchtkörper (6) tragenden Trägerkörper (4), wobei jeweils eine Ansteuereinheit (5) mit zumindest einem Leuchtkörper (6) verbunden ist,
die Ansteuereinheiten (5) zur Ansteuerung der damit verbundenen Leuchtkörper (6) abhängig von Lichtsignalen (LS) in der lichtleitenden Schicht (10) ausgebildet sind und mit den elektrisch leitfähigen Schichten (8, 9) und der lichtleitenden Schicht (10) verbunden sind,
wobei
zwischen den elektrisch leitfähigen Schichten (8, 9) eine elektrische Isolationsschicht (14) vorgesehen ist und die lichtleitende Schicht (10) zwischen der Oberseite (2) und der ersten elektrisch leitfähigen Schicht (8) angeordnet ist, in welcher lichtleitenden Schicht (10) Streuflächen (15) angeordnet sind, und/oder die lichtleitende Schicht (10) zwischen der zweiten elektrisch leitfähigen Schicht (9) und der Unterseite (3) angeordnet ist.

## Beschreibung

Eine Vorrichtung dieser Art ist aus der EP 3 368 822 B1 bekannt. Die Vorrichtung weist einen Trägerkörper auf, auf welchem mit jeweils einer Ansteuereinheit verbundene, einzeln ansteuerbare Leuchtkörper angeordnet sind. Der Trägerkörper weist zwei elektrisch leitfähige Schichten und eine dazwischen angeordnete lichtleitende Schicht zur Leitung von Lichtsignalen auf. Über lichterfassende Anschlüsse und elektrische Anschlüsse sind die Ansteuereinheiten mit der lichtleitenden Schicht und den elektrisch leitfähigen Schichten verbunden. Die Ansteuereinheiten sind zur Ansteuerung der Leuchtkörper in Abhängigkeit von in die lichtleitende Schicht eingespeisten Lichtsignalen ausgebildet.

Die bekannte Vorrichtung ermöglicht eine flexible Positionierung der Leuchtkörper auf einem einfach und kostengünstig herstellbaren Trägerkörper. Die Vorrichtung ist für eine Farb-, Zeichen- und/oder Bilddarstellung konstanter oder sich auch rasch veränderbarer Informationen für verschiedene Anwendungsbereiche ausgebildet. Zudem ist die Formgebung des Trägerkörpers im Anschluss an den Herstellungsvorgang durch einen Benutzer einfach zu ändern.

Wenn eine hohe Dichte von Leuchtkörpern auf dem Trägerkörper gewünscht ist, beispielsweise um eine hohe Bildauflösung zu erzielen, könnten jedoch die zahlreichen elektrischen Anschlüsse der Ansteuereinheiten, welche die lichtleitende Schicht durchsetzen, die Lichtausbreitung in der lichtleitenden Schicht durch Abschattung beeinträchtigen. Infolgedessen könnte an einem von einem Einspeisepunkt der Lichtsignale in die lichtleitende Schicht entfernten Ende der lichtleitenden Schicht zu wenig Licht auf die lichterfassenden Anschlüsse auftreffen, um eine zuverlässige Ansteuerung der Leuchtkörper zu gewährleisten. Vor allem bei großflächigen Trägerkörpern könnte dies zu Fehlern in der Bilddarstellung führen.

Es ist daher eine Aufgabe der Erfindung, eine Vorrichtung zur Bilddarstellung der eingangs genannten Art zu schaffen, welche die aus dem Stand der Technik bekannten Nachteile vermeidet oder zumindest verringert. Die Vorrichtung soll auch bei großformatigen Trägerkörpern und bei hoher Dichte der Leuchtkörper eine zuverlässige Versorgung aller Ansteuereinheiten mit Lichtsignalen ausreichender Stärke ermöglichen, um selbst an der vom Lichteinspeisepunkt am weitesten entfernten Position die Leuchtkörper korrekt über die Ansteuereinheiten ansteuern zu können. Die Vorrichtung soll einfach zu betreiben und robust sein. Zudem soll die Formgebung des Trägerkörpers im Anschluss an den Herstellungsvorgang durch einen Benutzer einfach zu ändern sein.

Diese Aufgabe wird durch eine Vorrichtung mit den Merkmalen von Anspruch 1 gelöst. Bevorzugte Ausführungen und Weiterbildungen sind in den abhängigen Ansprüchen angegeben.

Die Erfindung ist dadurch gekennzeichnet, dass zwischen der ersten elektrisch leitfähigen Schicht und der zweiten elektrisch leitfähigen Schicht eine elektrische Isolationsschicht vorgesehen ist und die zumindest eine lichtleitende Schicht zwischen der Oberseite und der ersten elektrisch leitfähigen Schicht angeordnet ist, in welcher lichtleitenden Schicht Streuflächen angeordnet sind, und/oder die zumindest eine lichtleitende Schicht zwischen der zweiten elektrisch leitfähigen Schicht und der Unterseite angeordnet ist.

Die Vorrichtung zur Bilddarstellung, worunter auch eine Videodarstellung zu verstehen ist, weist somit einen Trägerkörper mit einer Oberseite und einer der Oberseite gegenüberliegenden Unterseite auf. Die Oberseite und die Unterseite sind bevorzugt Außenseiten des Trägerkörpers. Der Trägerkörper kann starr oder flexibel, insbesondere biegsam, ausgebildet sein. Der Trägerkörper kann in beliebigen, im Wesentlichen durch das Herstellungsverfahren beschränkten Größen, beispielsweise von einigen cm² bis hin zu einigen m², hergestellt werden. Der Trägerkörper trägt Ansteuereinheiten und ansteuerbare Leuchtkörper, welche der Bilddarstellung dienen und insbesondere zur Abstrahlung von Licht in unterschiedlichen Farben und mit unterschiedlicher Helligkeit ausgebildet sein können. Die Leuchtkörper sind näher zur Oberseite als zur Unterseite angeordnet. Jeweils eine Ansteuereinheit ist mit zumindest einem Leuchtkörper physisch verbunden. Bevorzugt sind die Leuchtkörper auf die Ansteuereinheiten aufgesetzt, sie können jedoch auch neben den Ansteuereinheiten angeordnet sein. Bevorzugt bilden die einzelnen Ansteuereinheiten gemeinsam mit den damit verbundenen Leuchtkörpern einteilige Bildkörper. Die Bildkörper können auf den Trägerkörper aufgesetzt sein, in welchem Fall die Bildkörper bevorzugt mit einer lichtdurchlässigen Schutzschicht überzogen sind. Alternativ oder in Kombination damit können die Bildkörper zumindest zum Teil in den Trägerkörper eingesetzt oder eingebettet sein. Der Trägerkörper weist eine in einem ersten Abstand von der Oberseite angeordnete erste elektrisch leitfähige Schicht, eine in einem zweiten Abstand von der Oberseite angeordnete zweite elektrisch leitfähige Schicht und zumindest eine lichtleitende Schicht zur Leitung von Lichtsignalen auf. Da der zweite Abstand größer als der erste Abstand ist, ist die erste elektrisch leitfähige Schicht näher an der Oberseite als die zweite elektrisch leitfähige Schicht angeordnet. Die Ansteuereinheiten sind zur Ansteuerung der damit verbundenen Leuchtkörper in Abhängigkeit von in die lichtleitende Schicht eingespeisten Lichtsignalen ausgebildet.

Der Trägerkörper weist somit mehrere vorzugsweise flächig miteinander verbundene Schichten auf, von welchen die erste und zweite elektrisch leitfähige Schicht der Stromversorgung, vorzugsweise der Gleichstromversorgung, der Ansteuereinheiten und der jeweils damit verbundenen Leuchtkörper dient, während die lichtleitende Schicht der Übertragung von Lichtsignalen an die Ansteuereinheiten dient. Die Lichtsignale enthalten Informationen, insbesondere Steuer- und/oder Adressinformationen, für den Betrieb der Leuchtkörper. Diese Informationen werden von den mit der lichtleitenden Schicht verbundenen Ansteuereinheiten erfasst, wobei die Ansteuereinheiten ausgebildet sind, die Steuer- und Adressinformationen zu verarbeiten. Die Adressinformationen dienen der Adressierung einzelner Leuchtkörper oder einer definierten Gruppe von Leuchtkörpern. Insbesondere kann jeder Ansteuereinheit eine eigene Adresse zugewiesen sein oder es können zumindest zwei Ansteuereinheiten eine gleiche Adresse aufweisen. Zudem kann eine adressierte Ansteuereinheit mehrere damit verbundene Leuchtkörper unterschiedlich ansteuern, wenn die Steuerinformationen entsprechende Informationen enthalten. Die Steuerinformationen können beinhalten, ob ein Leuchtkörper aktiviert oder deaktiviert werden soll, welche Farbe dieser abstrahlen soll und/oder mit welcher Helligkeit dieser abstrahlen soll.

Für die Ansteuerung der Leuchtkörper sind die Ansteuereinheiten über erste elektrische Stromversorgungsanschlüsse mit der ersten elektrisch leitfähigen Schicht, über zweite elektrische Stromversorgungsanschlüsse mit der zweiten elektrisch leitfähigen Schicht und über lichterfassende Anschlüsse lichtleitend mit der lichtleitenden Schicht verbunden. Unter einer lichtleitenden Verbindung wird im Rahmen dieser Beschreibung eine Verbindung verstanden, welche eine Lichtübertragung gewährleistet. Die lichtleitende Verbindung ist nicht notwendigerweise eine mechanische Verbindung. Demnach kann auch ein Luftspalt eine lichtleitende Verbindung darstellen. Um die Lichtsignale auswerten zu können, weisen die Ansteuereinheiten oder die lichterfassenden Anschlüsse einen Lichtempfänger auf, welcher die Lichtsignale in elektrische Signale wandelt. Die lichterfassenden Anschlüsse sind als Lichtleiter ausgebildet, welche insbesondere die Lichtsignale von der lichtleitenden Schicht zum Lichtempfänger weiterleiten. Die ersten und zweiten elektrischen Stromversorgungsanschlüsse sind lichtundurchlässig oder zumindest lichtdämpfend ausgebildet und können beispielsweise als Stifte ausgebildet sein. Bevorzugt verlaufen die ersten und zweiten elektrischen Stromversorgungsanschlüsse senkrecht zur ersten und zweiten elektrisch leitfähigen Schicht.

Um durch die ersten und/oder zweiten elektrischen Stromversorgungsanschlüsse verursachte Abschattungen der Lichtsignale in der lichtleitenden Schicht zu reduzieren oder zu vermeiden, ist vorgesehen, dass zwischen der ersten elektrisch leitfähigen Schicht und der zweiten elektrisch leitfähigen Schicht eine elektrische Isolationsschicht vorgesehen ist und die zumindest eine lichtleitende Schicht zwischen der Oberseite und der ersten elektrisch leitfähigen Schicht angeordnet ist, in welcher lichtleitenden Schicht Streuflächen angeordnet sind, und/oder die zumindest eine lichtleitende Schicht zwischen der zweiten elektrisch leitfähigen Schicht und der Unterseite angeordnet ist. Im Unterschied zur Erfindung ist gemäß dem Stand der Technik die lichtleitende Schicht zwischen der ersten und zweiten elektrisch leitfähigen Schicht vorgesehen, weshalb die Stromversorgungsanschlüsse, welche die lichtleitende Schicht durchsetzen, Abschattung verursachen. Insbesondere bei großflächigen Trägerkörpern oder einer hohen Leuchtkörperdichte können die Stromversorgungsanschlüsse den Lichteinfall auf die lichterfassenden Anschlüsse so weit reduzieren, dass die Lichtsignale nicht mehr zuverlässig in den Ansteuereinheiten verarbeitet werden können. Demgegenüber ist gemäß der Erfindung zwischen der ersten elektrisch leitfähigen Schicht und der zweiten elektrisch leitfähigen Schicht eine elektrische Isolationsschicht vorgesehen, welche lichtundurchlässig sein kann und nicht der Lichtleitung der Lichtsignale dient. Wenn die zumindest eine lichtleitende Schicht zwischen der Oberseite und der ersten elektrisch leitfähigen Schicht angeordnet ist, in welchem Fall die lichtleitende Schicht in Rahmen dieser Beschreibung auch als obere lichtleitende Schicht bezeichnet wird, sind in der lichtleitenden Schicht Streuflächen angeordnet. Die Streuflächen streuen das darauf auftreffende Lichtsignal in zumindest eine von einer Lichteinfallsrichtung abweichende Richtung. Da bevorzugt zahlreiche Streuflächen in der lichtleitenden Schicht vorgesehen sind, wird das Lichtsignal in verschiedene Richtungen gestreut, sodass es auch Bereiche ausleuchtet die bei ungestreutem, geradlinigem Lichteinfall abgeschattet wären. Auf diese Weise werden jene Stromversorgungsanschlüsse oder allgemein lichtabschattenden Körper, welche in der zwischen der Oberseite und der ersten elektrisch leitfähigen Schicht angeordneten lichtleitenden Schicht aufgenommen sind, vom Lichtsignal umgangen. Wenn hingegen die zumindest eine lichtleitende Schicht zwischen der zweiten elektrisch leitfähigen Schicht und der Unterseite angeordnet ist, in welchem Fall die lichtleitende Schicht in Rahmen dieser Beschreibung auch als untere lichtleitende Schicht bezeichnet wird, werfen die Stromversorgungsanschlüsse keine Schatten in der lichtleitenden Schicht, da die Stromversorgungsanschlüsse in den über der lichtleitenden Schicht vorgesehenen elektrisch leitfähigen Schichten enden und die lichtleitende Schicht nicht durchsetzen.

Selbstverständlich kann die zumindest eine lichtleitende Schicht sowohl zwischen der Oberseite und der ersten elektrisch leitfähigen Schicht als auch zwischen der zweiten elektrisch leitfähigen Schicht und der Unterseite angeordnet sein. In diesem Fall können eine oder mehrere, identisch oder unterschiedlich ausgebildete lichtleitende Schichten zwischen der Oberseite und der ersten elektrisch leitfähigen Schicht und zusätzlich eine oder mehrere, identisch oder unterschiedlich ausgebildete lichtleitende Schichten zwischen der zweiten elektrisch leitfähigen Schicht und der Unterseite angeordnet sein.

Der Trägerkörper kann zusätzlich zur ersten und zweiten elektrisch leitfähigen Schicht, zur elektrischen Isolationsschicht und zur lichtleitenden Schicht weitere Schichten, beispielsweise zusätzliche Isolationsschichten, eine den Trägerkörper stützende Trageschicht, eine für die Anbringung des Trägerkörpers an einem Untergrund vorgesehene Selbstklebeschicht und/oder eine die Leuchtkörper schützende lichtdurchlässige Schutzschicht aufweisen.

Die erfindungsgemäße Vorrichtung erlaubt nicht nur einen zuverlässigen Betrieb von dicht aneinander gepackten Leuchtkörpern am Trägerkörper, sondern auch einen nachträglichen Zuschnitt des Trägerkörpers, da die für die Stromversorgung und die Übertragung von Lichtsignalen vorgesehenen Schichten flächig miteinander verbunden sind und ein Abtrennen eines Teilabschnitts die Funktion der hierdurch formveränderten Vorrichtung nicht beeinträchtigt. Günstiger Weise ist der Trägerkörper aus mit einfachen Werkzeugen trennbaren Materialien aufgebaut.

Wenn im Verlauf der Beschreibung auf Orts- und Richtungsangaben wie beispielsweise "oben", "unten, "darüber", "darunter", "vorne", "hinten" oder "seitlich" Bezug genommen wird, so beziehen sich diese Angaben auf einen Verwendungszustand der Vorrichtung, in welchem der Trägerkörper auf einer horizontalen Ebene aufliegt und die Leuchtkörper von der horizontalen Ebene wegweisen. Der Begriff "oben" definiert insbesondere eine Position, die der Oberseite des Trägerkörpers näher ist als eine durch den Begriff "unten" definierte Position. Der Begriff "vertikal" bedeutet in Richtung der Schwerkraft, von "oben" nach "unten", oder umgekehrt. Selbstverständlich kann die Vorrichtung in einer abweichenden Lage verwendet werden, beispielsweise mit vertikal angeordnetem Trägerkörper oder hängend mit beliebiger Orientierung der Oberseite des Trägerkörpers, in welchem Fall die Orts- und Richtungsangaben entsprechend zu übertragen sind.

Gemäß einer bevorzugten Ausführungsform der Erfindung ist vorgesehen, dass sich zumindest Teilabschnitte der lichterfassenden Anschlüsse und/oder der ersten elektrischen Stromversorgungsanschlüsse und/oder der zweiten elektrischen Stromversorgungsanschlüsse in Ausnehmungen im Trägerkörper erstrecken. Die Ausnehmungen weisen ein den Ansteuereinheiten zugewandtes offenes erstes Ende auf und können als Vertiefungen mit einem zweiten Ende im Trägerkörper enden oder als Durchgangsöffnungen mit einem zweiten offenen Ende den Trägerkörper durchsetzen. Die Ausnehmungen ermöglichen ein Einsetzen der lichterfassenden Anschlüsse und/oder der ersten oder zweiten elektrischen Stromversorgungsanschlüsse, welche im weiteren Verlauf der Beschreibung fallweise auch nur als Anschlüsse oder im Fall der elektrischen Anschlüsse als Stromversorgungsanschlüsse bezeichnet werden, in den Trägerkörper, ohne die Anschlüsse in den Trägerkörper einstechen zu müssen. Somit können die Anschlüsse größere Querschnittsabmessung aufweisen und im Vergleich zu Einstechkontakten noch zuverlässigere lichtleitende oder elektrische Kontakte herstellen. Zudem wird der Trägerkörper nicht durch einen Einstechvorgang mechanisch belastet. Die in Ausnehmungen aufgenommenen Anschlüsse können mit zum Einstechen ausgebildeten Anschlüssen kombiniert werden. Zum Einstechen ausgebildete Anschlüsse können vorteilhaft an beliebigen Positionen am Trägerkörper angeordnet werden. Zum Einstechen ausgebildete Anschlüsse sind an dem von der Ansteuereinheit abgewandten Ende bevorzugt spitz zulaufend, beispielsweise nadelförmig, kegelförmig oder pyramidenförmig ausgebildet. Beispielsweise können die Stromversorgungsanschlüsse zum Einstechen ausgebildet sein und die lichterfassenden Anschlüsse in Ausnehmungen aufgenommen sein.

Für eine besonders einfache Konstruktion können die Ausnehmungen eine Tiefenerstreckung aufweisen, entlang welcher Querschnittsabmessungen der Ausnehmungen konstant sind. Die Ausnehmungen können somit rohrförmig, insbesondere in der Form einer Sackbohrung oder einer Durchgangsöffnung, mit eckigem oder rundem Querschnittsprofil ausgebildet sein. Die Tiefenerstreckung weist eine Orientierung von der Oberseite zur Unterseite des Trägerkörpers auf. Die Querschnittsabmessungen werden in Ebenen senkrecht zur Tiefenerstreckung gemessen und können in unterschiedlichen Querrichtungen unterschiedliche Werte aufweisen. Im Fall der Ausnehmungen mit konstanten Querschnittsabmessungen kann es vorteilhaft sein, die einer Ansteuereinheit zugeordneten Anschlüsse in unterschiedlichen Ausnehmungen aufzunehmen, sodass jede Ausnehmung in jener Schicht des Trägerkörpers endet, die für die Verbindung mit dem in der Ausnehmung aufgenommenen Anschluss vorgesehen ist.

Wenn hingegen die Ausnehmungen eine Tiefenerstreckung aufweisen, entlang welcher eine erste Querschnittsabmessung der Ausnehmung in der ersten elektrisch leitfähigen Schicht größer als eine zweite Querschnittsabmessung der Ausnehmung in der elektrischen Isolationsschicht ist und diese größer als eine dritte Querschnittsabmessung der Ausnehmung in der zweiten elektrisch leitfähigen Schicht ist, kann für die Stromversorgungsanschlüsse und optional für den zumindest einen lichterfassenden Anschluss einer Ansteuereinheit eine einzige Ausnehmung vorgesehen sein. Bevorzugt sind die unterschiedlich großen Querschnittsformen der Ausnehmung in den einzelnen Schichten des Trägerkörpers symmetrisch zu einer Mittellinie der Ausnehmung ausgebildet und besonders bevorzugt als übereinander angeordnete Kreise mit unterschiedlichem Durchmesser und gleicher Mittellinie ausgebildet. Unabhängig von der konkreten Ausbildung der Querschnittsflächen ermöglichen die unterschiedlichen Querschnittsabmessungen vorzugsweise die Stromversorgungsanschlüsse auf die erste und zweite elektrisch leitfähige Schicht aufzusetzen, besonders bevorzugt unter Ausbildung einer großen Kontaktfläche. Wenn der lichterfassende Anschluss zwischen den Stromversorgungsanschlüssen hindurchgeführt ist, kann zudem der lichterfassende Anschluss mit einer großen Lichtaufnahmefläche ausgebildet und lichtleitend mit der lichtleitenden Schicht verbunden werden.

Für eine zuverlässige Versorgung der lichterfassenden Anschlüsse mit den Lichtsignalen ist es vorteilhaft, wenn die Streuflächen an den ersten und/oder zweiten elektrischen Stromversorgungsanschlüssen und/oder an Wänden der Ausnehmungen vorgesehen sind. Auf diese Weise kann auf eigens in die lichtleitende Schicht eingebrachte und Streuflächen aufweisende Streukörper verzichtet werden. Dennoch können solche Streukörper während des Herstellungsvorgangs des Trägerkörpers oder nachträglich zusätzlich in die lichtleitende Schicht eingebracht werden. Die Streuflächen können auf jene Abschnitte der Stromversorgungsanschlüsse und Ausnehmungen begrenzt sein, die in der lichtleitenden Schicht liegen. Vorzugsweise sind die Streuflächen entlang des Umfangs der Stromversorgungsanschlüsse und/oder entlang des Umfangs der Wände der Ausnehmungen angeordnet. Die Streuflächen können aus lichtdurchlässigem Material gebildet sein.

Für die Herstellung einer besonders dünnen Vorrichtung kann vorgesehen sein, dass zumindest eine Ansteuereinheit jener Ansteuereinheiten, die lichtleitend mit der zwischen der Oberseite und der ersten elektrisch leitfähigen Schicht angeordneten lichtleitenden Schicht verbunden sind, innerhalb einer Ansteuereinheit-Ausnehmung angeordnet ist, welche in der zwischen der Oberseite und der ersten elektrisch leitfähigen Schicht angeordneten lichtleitenden Schicht vorgesehen ist. Bevorzugt sind alle Ansteuereinheiten, die lichtleitend mit der zwischen der Oberseite und der ersten elektrisch leitfähigen Schicht angeordneten lichtleitenden Schicht verbunden sind, in den Ansteuereinheit-Ausnehmungen angeordnet. Wenn somit zwischen der Oberseite und der ersten elektrisch leitfähigen Schicht eine lichtleitende Schicht vorgesehen ist, kann diese obere lichtleitende Schicht Ansteuereinheit-Ausnehmungen aufweisen, in welche die Ansteuereinheiten eingesetzt sind. Bevorzugt ist eine Ansteuereinheit pro Ansteuereinheit-Ausnehmung vorgesehen, es können jedoch auch mehrere Ansteuereinheiten in einer gemeinsamen Ansteuereinheit-Ausnehmung vorgesehen sein. Weiters kann vorgesehen sein, dass auch die Leuchtkörper und somit die aus Leuchtkörper und Ansteuereinheit gebildeten Bildkörper in den Ansteuereinheit-Ausnehmungen angeordnet sind. Beispielsweise können hierfür die Höhe der lichtleitenden Schicht und die Höhe der Bildkörper im Wesentlichen gleich groß sein. Für die Verbindung der in die lichtleitende Schicht eingesetzten Ansteuereinheiten mit der lichtleitenden Schicht können beispielsweise die lichterfassenden Anschlüsse in der Ansteuereinheit-Ausnehmung verlaufen, insbesondere in einer Ebene parallel zur lichtleitenden Schicht. Die Stromversorgungsanschlüsse können sich senkrecht zur lichtleitenden Schicht erstrecken. Die Ansteuereinheit-Ausnehmungen können Durchgangsöffnungen in der lichtleitenden Schicht sein oder sie können in Richtung der Oberseite des Trägerkörpers durch eine geschlossene Deckenfläche und/oder in Richtung der Unterseite des Trägerkörpers durch eine geschlossene Bodenfläche bedeckt sein, wobei die Deckenfläche und die Bodenfläche durch Abschnitte der lichtleitenden Schicht gebildet sind.

Die Streuung der Lichtsignale in der zwischen der Oberseite und der ersten elektrisch leitfähigen Schicht angeordneten lichtleitenden Schicht kann besonders vorteilhaft erfolgen, wenn die Ansteuereinheit-Ausnehmungen umgebende Begrenzungsränder der lichtleitenden Schicht die Streuflächen aufweisen und insbesondere die Begrenzungsränder von zumindest zwei Ansteuereinheit-Ausnehmungen, vorzugsweise von zumindest der Hälfte der Ansteuereinheit-Ausnehmungen, angeordnet sind, die Lichtsignale zwischen den Begrenzungsrändern umzulenken. Hierdurch können die in der oberen lichtleitenden Schicht gebildeten Begrenzungsränder der Ansteuereinheit-Ausnehmungen für die Umlenkung der Lichtsignale um die Ansteuereinheit-Ausnehmungen und somit um die Bildkörper herum genutzt werden. Insbesondere können die Lichtsignale zwischen einer Vielzahl von Begrenzungsrändern mehrfach in unterschiedliche Richtungen umgelenkt werden. Die Streuflächen können beispielsweise durch Unebenheiten der Begrenzungsränder und/oder durch auf die Begrenzungsränder aufgebrachte Beschichtungen gebildet sein.

Besonders vorteilhaft können die Lichtsignale umgelenkt und gestreut werden, wenn die Begrenzungsränder rund ausgebildet sind und/oder die Begrenzungsränder mit zumindest drei Ecken und zwischen den Ecken verlaufenden Randabschnitten ausgebildet sind, wobei insbesondere einander zugewandte Randabschnitte benachbarter Ansteuereinheit-Ausnehmungen unterschiedlich orientiert sind. Die Begrenzungsränder können somit rund oder mehreckig ausgebildet sein. Für die Umlenkung der Lichtsignale können unterschiedliche Ansteuereinheit-Ausnehmungen unterschiedliche Formen und/oder Abmessungen aufweisen. Ebenso können unterschiedliche Ansteuereinheit-Ausnehmungen mit unterschiedlicher Orientierung in die lichtleitende Schicht eingebracht sein. Die unterschiedlich orientierten und einander zugewandten Randabschnitte benachbarter Ansteuereinheit-Ausnehmungen können insbesondere nicht-parallel zueinander ausgebildet sein, d.h. in unterschiedliche Richtungen weisen.

Für die Verbindung der Ansteuereinheiten mit dem Trägerkörper kann vorgesehen sein, dass die lichtleitende Schicht und/oder die erste elektrisch leitfähige Schicht und/oder die zweite elektrisch leitfähige Schicht eben ausgebildet ist oder uneben mit den lichterfassenden Anschlüssen zugewandten lichtleitenden Erhöhungen und/oder den ersten elektrischen Stromversorgungsanschlüssen zugewandten elektrisch leitenden Erhöhungen und/oder den zweiten elektrischen Stromversorgungsanschlüssen zugewandten elektrisch leitenden Erhöhungen ausgebildet ist. Wenn die Schichten des Trägerkörpers eben ausgebildet sind, weisen die Ansteuereinheiten entsprechend lang ausgebildete Anschlüsse auf, welche sich von einem Hauptkörper der Ansteuereinheiten erstrecken, damit die Anschlüsse die jeweils dafür vorgesehene Schicht kontaktieren. Wenn hingegen die Schichten des Trägerkörpers uneben mit den Erhöhungen ausgebildet sind, welche Erhöhungen sich in der Richtung von der Unterseite des Trägerkörpers zur Oberseite des Trägerkörpers erstrecken, können die Anschlüsse der Ansteuereinheiten vergleichsweise kürzer ausgebildet sein. Wenn sich die Erhöhungen bis zu den Ansteuereinheiten erstrecken, können die Anschlüsse der Ansteuereinheiten eben mit einer Bodenfläche der Hauptkörper ausgebildet sein. In diesem Fall bilden die Erhöhungen elektrische und/oder optische Kontakte des Trägerkörpers, auf welche die Ansteuereinheiten aufgesetzt werden. Wenn sich die Erhöhungen weiter über die Bodenfläche der Hauptkörper hinaus nach oben erstrecken, können die Anschlüsse der Ansteuereinheiten in den Hauptkörper hinein zurückversetzt sein. Die Anschlüsse der Ansteuereinheiten müssen daher nicht vom Hauptkörper der Ansteuereinheiten abstehen.

Für die lichtleitende Verbindung der Ansteuereinheiten mit der lichtleitenden Schicht wird bevorzugt, dass die lichterfassenden Anschlüsse mit einem ersten Ende fest mit den Ansteuereinheiten verbunden sind und mit einem dem ersten Ende gegenüberliegenden zweiten Ende in die lichtleitende Schicht eingestochen sind oder auf der lichtleitenden Schicht aufliegen oder in einem die Lichtleitung gewährleistenden Abstand zur lichtleitenden Schicht angeordnet sind. Wenn das zweite Ende der lichterfassenden Anschlüsse eine Spitze aufweist und in die lichtleitende Schicht eingestochen ist, erfolgt der Lichtübergang von der lichtleitenden Schicht in den lichterfassenden Anschluss zumindest über die Spitze. Wenn das zweite Ende der lichterfassenden Anschlüsse eine Fläche, insbesondere eine Ebene aufweist und auf der lichtleitenden Schicht aufliegt, erfolgt der Lichtübergang von der lichtleitenden Schicht in den lichterfassenden Anschluss zumindest über die Fläche, insbesondere über die Ebene. Wenn das zweite Ende der lichterfassenden Anschlüsse eine Spitze oder eine Fläche, insbesondere eine Ebene aufweist und in einem die Lichtleitung gewährleistenden Abstand zur lichtleitenden Schicht angeordnet ist, erfolgt der Lichtübergang von der lichtleitenden Schicht in den lichterfassenden Anschluss zumindest über den zwischen dem zweiten Ende und der lichtleitenden Schicht verbleibenden Spalt.

Für die lichtleitende Verbindung der Ansteuereinheiten mit der lichtleitenden Schicht wird weiters bevorzugt, dass die lichterfassenden Anschlüsse mit einem ersten Ende fest mit den Ansteuereinheiten verbunden sind und mit einem dem ersten Ende gegenüberliegenden zweiten Ende entweder auf der lichtleitenden Schicht aufliegen oder in einem die Lichtleitung gewährleistenden Abstand zur lichtleitenden Schicht angeordnet sind, wobei die lichtleitende Schicht an der Position der aufliegenden lichterfassenden Anschlüsse oder an der Position einer gedachten Verlängerung der beabstandeten lichterfassenden Anschlüsse eine größere Unebenheit als neben diesen Positionen aufweist. Mittels der größeren Unebenheit kann das Lichtsignal besonders zuverlässig aus der lichtleitenden Schicht austreten und in die zweiten Enden der auf der lichtleitenden Schicht aufliegenden oder davon beabstandeten lichterfassenden Anschlüsse eintreten. Die größere Unebenheit kann beispielsweise durch Aufrauhen der lichtleitenden Schicht oder durch ein in die lichtleitende Schicht eingebrachtes Profil hergestellt werden.

Für die elektrische Verbindung der Ansteuereinheiten mit den elektrisch leitfähigen Schichten des Trägerkörpers können bevorzugt die ersten und/oder zweiten elektrischen Stromversorgungsanschlüsse mit einem ersten Ende fest mit der Ansteuereinheit verbunden sein und mit einem dem ersten Ende gegenüberliegenden zweiten Ende in die erste elektrisch leitfähige Schicht und/oder in die zweite elektrisch leitfähige Schicht eingestochen sein oder darauf aufliegen. Wenn das zweite Ende der Stromversorgungsanschlüsse eine Spitze aufweist und in die jeweilige elektrisch leitfähige Schicht eingestochen ist, erfolgt der Stromfluss von den elektrisch leitfähigen Schichten in die Stromversorgungsanschlüsse zumindest über die Spitze. Wenn das zweite Ende der Stromversorgungsanschlüsse eine Fläche, insbesondere eine Ebene aufweist und auf der jeweiligen elektrisch leitfähigen Schicht aufliegt, erfolgt der Stromfluss von den elektrisch leitfähigen Schichten in die Stromversorgungsanschlüsse zumindest über die Fläche, insbesondere über die Ebene.

Um eine bevorzugte Ausführungsform mit einem besonders ansprechenden äußeren Erscheinungsbild zu schaffen, können alle Schichten des Trägerkörpers aus lichtdurchlässigem Material gebildet sein. Hierdurch wird der visuelle Eindruck, den ein Benutzer durch die Bilddarstellung am Trägerkörper erhält, durch das durch den Trägerkörper passierende Licht noch ergänzt. Beispielsweise können durch den Trägerkörper hindurch sichtbare Farbmuster die Bilddarstellung an der Oberseite des Trägerkörpers ergänzen. Das lichtdurchlässige Material kann transparent oder transluzent sein.

Weiters kann vorgesehen sein, dass die Leuchtkörper Leuchtdioden oder elektrisch verformbare und Umgebungslicht brechende Kristalle oder elektrisch steuerbare Reflexionskörper sind. Leuchtdioden bieten den Vorteil geringer Kosten, einer einfachen Steuerbarkeit und einer Bilddarstellung am Trägerkörper auch ohne Umgebungslicht. Demgegenüber können die Kristalle vorteilhafterweise durch elektrische Energie gezielt verformt werden und hierdurch Umgebungslicht in einer für die Bilddarstellung geeigneten Weise brechen und eine durch die Brechung generiere Lichtfarbe des Umgebungslichts zu einem Betrachter zurückleiten. Während die Verformung der Kristalle und daher die Einstellung der abgegebenen Lichtfarbe einmalig elektrischen Strom erfordert, kann darauf folgend unter Anwesenheit von Umgebungslicht die eingestellte Lichtfarbe ohne weitere Stromzufuhr abgegeben werden.

Die Erfindung wird nachstehend anhand von bevorzugten Ausführungsbeispielen, auf welche sie jedoch nicht beschränkt sein soll, noch weiter erläutert. In den Zeichnungen zeigen:
Fig. 1 einen Abschnitt einer Vorrichtung gemäß der Erfindung, mit der lichtleitenden Schicht zwischen der zweiten elektrisch leitfähigen Schicht und der Unterseite, in einer Querschnittsansicht;
Fig. 2 einen Abschnitt einer Vorrichtung gemäß der Erfindung, mit der lichtleitenden Schicht zwischen der Oberseite und der ersten elektrisch leitfähigen Schicht, wobei in der lichtleitenden Schicht Streuflächen angeordnet sind, in einer Querschnittsansicht;
Fig. 3 einen Abschnitt einer Vorrichtung gemäß der Erfindung, mit einer lichtleitenden Schicht zwischen der zweiten elektrisch leitfähigen Schicht und der Unterseite und einer lichtleitenden Schicht zwischen der Oberseite und der ersten elektrisch leitfähigen Schicht, in einer Querschnittsansicht;
Fig. 4 einen Abschnitt einer Vorrichtung gemäß der Erfindung, mit der lichtleitenden Schicht zwischen der zweiten elektrisch leitfähigen Schicht und der Unterseite und mit Anschlüssen einer Ansteuereinheit in Ausnehmungen im Trägerkörper, in einer Querschnittsansicht;
Fig. 5 einen Abschnitt einer Vorrichtung gemäß der Erfindung, mit der lichtleitenden Schicht zwischen der Oberseite und der ersten elektrisch leitfähigen Schicht und mit Anschlüssen einer Ansteuereinheit in Ausnehmungen im Trägerkörper, in einer Querschnittsansicht;
Fig. 6 einen Abschnitt eines Trägerkörpers mit einer Ausnehmung, welche in Tiefenrichtung konstante Querschnittsabmessungen aufweist, und mit Unebenheiten in der lichtleitenden Schicht, in perspektivischer Querschnittsansicht;
Fig. 7 einen Abschnitt eines Trägerkörpers mit einer Ausnehmung, welche in unterschiedlichen Schichten unterschiedliche Querschnittsabmessungen aufweist, und mit Unebenheiten in der lichtleitenden Schicht, in perspektivischer Querschnittsansicht;
Fig. 8 einen Abschnitt eines Trägerkörpers mit einer Ausnehmung, welche in unterschiedlichen Schichten unterschiedliche Querschnittsabmessungen aufweist, ohne zusätzliche Unebenheiten in der lichtleitenden Schicht, in perspektivischer Querschnittsansicht;
Fig. 9 einen Trägerkörper mit Ausnehmungen, welche in unterschiedlichen Schichten des Trägerkörpers unterschiedliche Querschnittsabmessungen aufweisen, in perspektivischer Ansicht;
Fig. 10 einen Abschnitt einer Vorrichtung gemäß der Erfindung, mit einer Ansteuereinheit, welche innerhalb einer Ansteuereinheit-Ausnehmung in einer zwischen der Oberseite und der ersten elektrisch leitfähigen Schicht angeordneten lichtleitenden Schicht angeordnet ist, in einer Querschnittsansicht;
Fig. 11 einen Abschnitt einer Vorrichtung gemäß der Erfindung, mit die Ansteuereinheit-Ausnehmungen umgebenden Begrenzungsrändern in der lichtleitenden Schicht, in einer Ansicht von oben;
Fig. 12 einen Abschnitt einer Vorrichtung gemäß der Erfindung, mit im Vergleich zu Fig. 11 unterschiedlich ausgebildeten Begrenzungsrändern, in einer Ansicht von oben;
Fig. 13 einen Abschnitt einer Vorrichtung gemäß der Erfindung, mit im Vergleich zu Fig. 11 und Fig. 12 unterschiedlich ausgebildeten Begrenzungsrändern, in einer Ansicht von oben;
Fig. 14 einen durch einen Leuchtkörper und eine Ansteuereinheit gebildeten Bildkörper;
Fig. 15 einen Abschnitt einer Vorrichtung gemäß der Erfindung, mit uneben, lichtleitenden und elektrisch leitenden Schichten, welche den Anschlüssen zugewandte lichtleitende und elektrisch leitenden Erhöhungen aufweisen, in einer Querschnittsansicht; und
Fig. 16 einen Abschnitt einer Vorrichtung gemäß der Erfindung, mit einem lichterfassenden Anschluss in einem die Lichtleitung gewährleistenden Abstand zur lichtleitenden Schicht und mit Unebenheiten in der lichtleitenden Schicht unterhalb des lichterfassenden Anschlusses, in einer Querschnittsansicht.

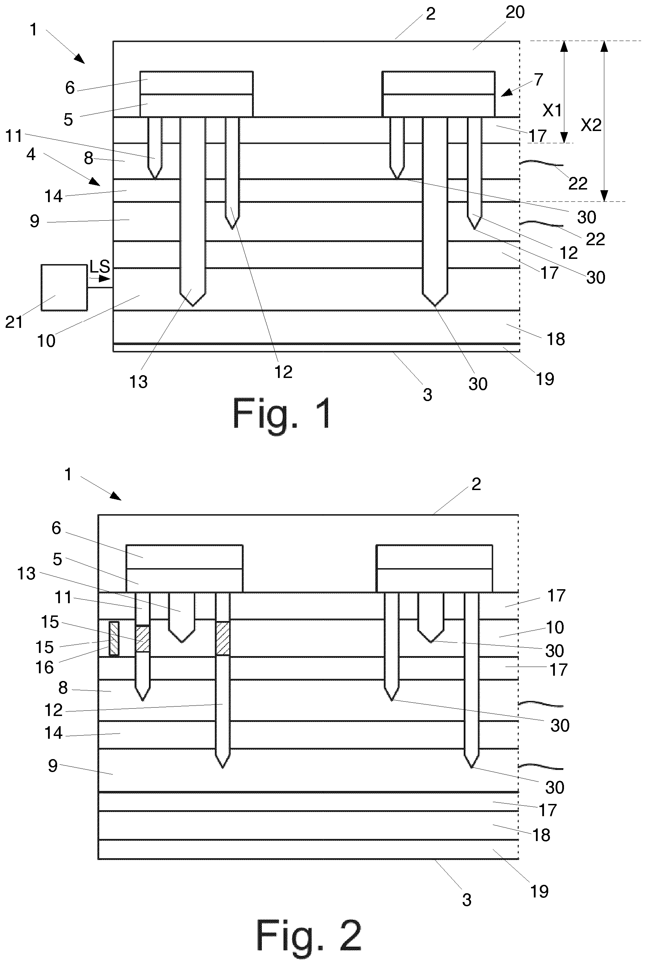

Es sei darauf hingewiesen, dass die Figuren 1 bis 16 nicht notwendigerweise maßstabsgetreu dargestellt sind. Zudem sind der Übersichtlichkeit wegen nicht alle anwendbaren Merkmale in allen Figuren dargestellt.

Fig. 1 zeigt beispielhaft einen Abschnitt einer Vorrichtung 1 zur Bilddarstellung. Die Vorrichtung 1 weist einen eine Oberseite 2 und eine Unterseite 3 aufweisenden Trägerkörper 4 auf. Der Trägerkörper 4 trägt Ansteuereinheiten 5 und ansteuerbare Leuchtkörper 6. Die Leuchtkörper 6 sind näher zur Oberseite 2 als zur Unterseite 3 angeordnet. Jeweils eine Ansteuereinheit 5 ist mit zumindest einem Leuchtkörper 6 verbunden. Eine Ansteuereinheit 5 und der damit verbundene zumindest eine Leuchtkörper 6 bilden gemeinsam einen Bildkörper 7. In Fig. 1 sind nur zwei Bildkörper 7 dargestellt. Selbstverständlich kann die Vorrichtung 1 eine Vielzahl von Bildkörpern 7, beispielsweise zumindest 10 oder zumindest 100 oder zumindest 1000 Bildkörper 7 aufweisen. Der Trägerkörper 4 weist eine in einem ersten Abstand X1 von der Oberseite 2 angeordnete erste elektrisch leitfähige Schicht 8, eine in einem zweiten Abstand X2 von der Oberseite 2 angeordnete zweite elektrisch leitfähige Schicht 9 und zumindest eine lichtleitende Schicht 10 zur Leitung von Lichtsignalen auf. In Fig. 1 ist deutlich erkennbar, dass der zweite Abstand X2 größer als der erste Abstand X1 ist. Die Ansteuereinheiten 5 sind zur Ansteuerung der damit verbundenen Leuchtkörper 6 in Abhängigkeit von in die lichtleitende Schicht 10 eingespeisten Lichtsignalen LS ausgebildet. Insbesondere sind die Ansteuereinheiten 5 ausgebildet, die jeweils damit verbundenen Leuchtkörper 6 zu aktivieren und zu deaktivieren, sofern die Leuchtkörper 6 aktivierbar und deaktivierbar sind, und/oder die Helligkeit und/oder die Lichtfarbe des von den Leuchtkörpern 6 abgestrahlten Lichts zu steuern. Die Leuchtkörper 6 sind beispielsweise zwischen der Oberseite 2 und der ersten elektrisch leitfähigen Schicht 8 oder auf der Oberseite 2 oder in der Oberseite 2 angeordnet. Die Ansteuereinheiten 5 sind zur Stromversorgung über erste elektrische Stromversorgungsanschlüsse 11 mit der ersten elektrisch leitfähigen Schicht 8 und über zweite elektrische Stromversorgungsanschlüsse 12 mit der zweiten elektrisch leitfähigen Schicht 9 verbunden und zur Ansteuerung der Leuchtkörper 6 über lichterfassende Anschlüsse 13 lichtleitend mit der zumindest einen lichtleitenden Schicht 10 verbunden. Jede der Ansteuereinheiten 5 kann über einen, zwei oder mehr als zwei lichterfassende Anschlüsse 13 lichtleitend mit der einer oder den mehreren lichtleitenden Schichten 10 verbunden sein. Die beiden Stromversorgungsanschlüsse 11, 12 können an Teilen ihrer Außenfläche eine elektrische Isolation aufweisen. Insbesondere sind die zweiten elektrischen Stromversorgungsanschlüsse 12, welche die erste elektrisch leitfähige Schicht 8 durchdringen, gegenüber der ersten elektrisch leitfähigen Schicht 8 elektrisch isoliert. Im Beispiel gemäß Fig. 1 sind die Stromversorgungsanschlüsse 11, 12 und der lichterfassende Anschluss 13 in die damit zu verbindende Schicht eingestochen. Die lichtleitende Schicht 10 und die lichterfassenden Anschlüsse 13 sind bevorzugt aus Kunststoff gebildet.

Da die lichtleitende Schicht 10 nicht zwischen den beiden elektrisch leitfähigen Schichten 8, 9 vorgesehen ist, ist zwischen der ersten elektrisch leitfähigen Schicht 8 und der zweiten elektrisch leitfähigen Schicht 9 eine elektrische Isolationsschicht 14 vorgesehen. Zur Vermeidung von beispielsweise durch die Stromversorgungsanschlüsse 11, 12 verursachten Abschattungen in der lichtleitenden Schicht 10, ist die zumindest eine lichtleitende Schicht 10 zwischen der Oberseite 2 und der ersten elektrisch leitfähigen Schicht 8 und/oder zwischen der zweiten elektrisch leitfähigen Schicht 9 und der Unterseite 3 angeordnet. Wenn die zumindest eine lichtleitende Schicht 10 zwischen der Oberseite 2 und der ersten elektrisch leitfähigen Schicht 8 angeordnet ist, sind in der lichtleitenden Schicht 10 Streuflächen 15 angeordnet, welche das in die lichtleitende Schicht 10 eingespeiste Lichtsignal LS umlenken und streuen.

Fig. 1 zeigt die zumindest eine lichtleitende Schicht 10 zwischen der zweiten elektrisch leitfähigen Schicht 9 und der Unterseite 3.

Fig. 2 zeigt eine Vorrichtung 1 mit der zumindest einen lichtleitenden Schicht 10 zwischen der Oberseite 2 und der ersten elektrisch leitfähigen Schicht 8.

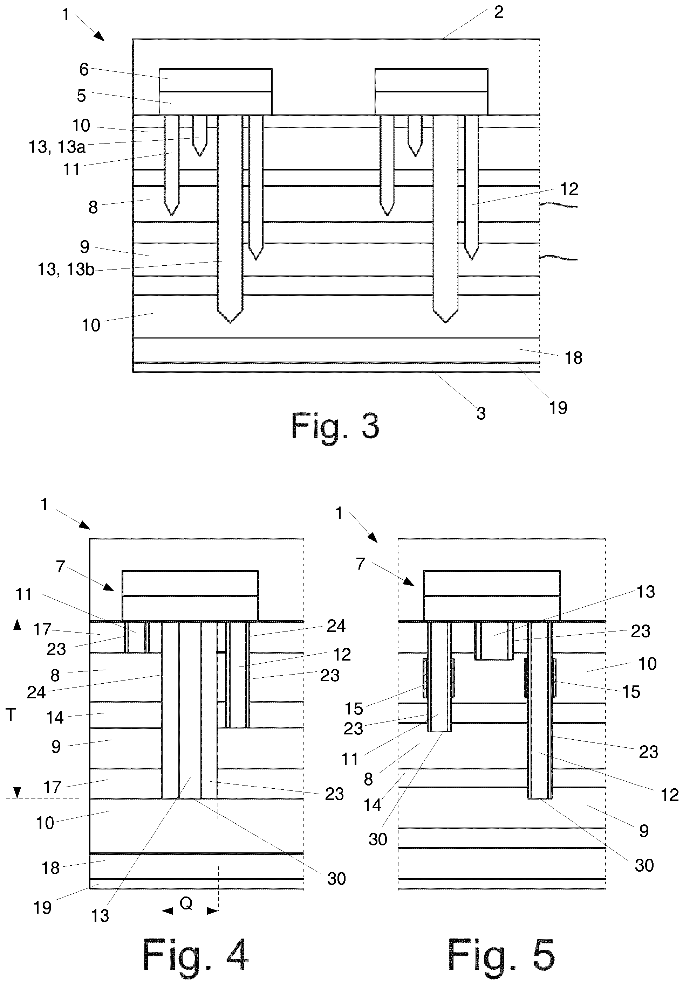

Fig. 3 zeigt eine Vorrichtung 1 mit zumindest einer lichtleitenden Schicht 10 zwischen der zweiten elektrisch leitfähigen Schicht 9 und der Unterseite 3 und mit zumindest einer zusätzlichen lichtleitenden Schicht 10 zwischen der Oberseite 2 und der ersten elektrisch leitfähigen Schicht 8. Die Ansteuereinheiten 5 sind hierbei über zwei lichterfassende Anschlüsse 13 mit den lichtleitenden Schichten 10 verbunden, wobei ein erster lichterfassender Anschluss 13a mit der oberen lichtleitenden Schicht 10 und ein zweiter lichterfassender Anschluss 13b mit der unteren lichtleitenden Schicht 10 verbunden ist.

Die Streuflächen 15 können durch Oberflächen von in die lichtleitende Schicht 10 eingebrachten, insbesondere lichtdurchlässsigen Streukörpern 16 (siehe Fig. 2) oder durch das Material der lichtleitenden Schicht 10 selbst gebildet sein. Die Streuflächen 15 können gleichmäßig in der lichtleitenden Schicht 10 verteilt sein oder ungleichmäßig verteilt sein, beispielsweise mit zunehmender Anzahl bei abnehmendem Abstand von den Stromversorgungsanschlüssen 11, 12. Im Beispiel gemäß Fig. 2 sind die Streuflächen 15 auch an den ersten und/oder zweiten elektrischen Stromversorgungsanschlüssen 11, 12 vorgesehen.

Fig. 1 zeigt weiters beispielhaft zusätzliche optionale Schichten des Trägerkörpers 4, insbesondere zusätzliche Isolationsschichten 17 zwischen den Ansteuereinheiten 5 und der ersten elektrisch leitfähigen Schicht 8 sowie zwischen der zweiten elektrisch leitfähigen Schicht 9 und der lichtleitenden Schicht 10, eine den Trägerkörper 4 stützende und zusätzliche Stabilität verleihende Trageschicht 18 an der Unterseite der lichtleitenden Schicht 10, eine für die Anbringung des Trägerkörpers 4 an einem Untergrund vorgesehene Selbstklebeschicht 19 an der Unterseite der Trageschicht 18 und/oder eine die Leuchtkörper 6 bedeckende und somit schützende lichtdurchlässige Schutzschicht 20.

Fig. 1 zeigt zudem beispielhaft eine Lichteinspeisevorrichtung 21 zur Einspeisung von Lichtsignalen LS in die zumindest eine lichtleitende Schicht 10 sowie elektrische Anschlussleitungen 22, zur Verbindung der ersten und zweiten elektrisch leitfähigen Schicht 8, 9 mit einer nicht dargestellten Stromquelle.

Die Figuren 4, 5, 10 und 16 zeigen Ausnehmungen 23 im Trägerkörper 4 in welchen sich zumindest Teilabschnitte der lichterfassenden Anschlüsse 13 und/oder der ersten elektrischen Stromversorgungsanschlüsse 11 und/oder der zweiten elektrischen Stromversorgungsanschlüsse 12 erstrecken. Die Anschlüsse der Ansteuereinheiten 5 können somit einfach in die Ausnehmungen 23 eingesetzt werden. Die in den Figuren 4, 5, 10 und 16 ersichtlichen Ausnehmungen 23 weisen eine Tiefenerstreckung T auf, entlang welcher Querschnittsabmessungen Q der Ausnehmungen 23 konstant sind. Insbesondere können die Ausnehmungen 23 von zylinderförmigen Wänden 24 begrenzt sein. Im Beispiel gemäß Fig. 5 sind Streuflächen 15 an den Wänden 24 von zwei Ausnehmungen 23 symbolisch dargestellt.

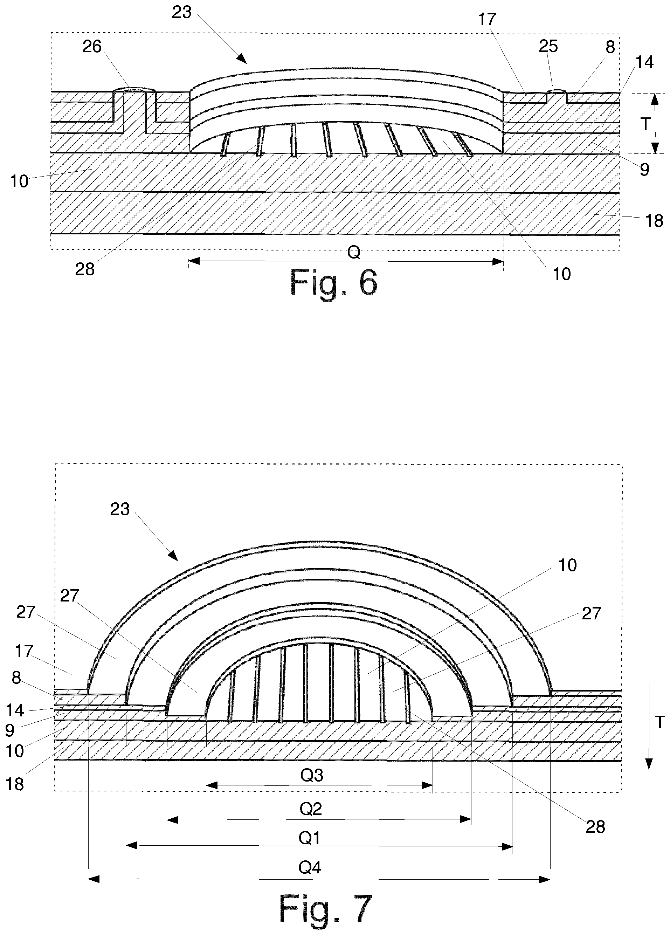

Fig. 6 zeigt eine Ausnehmung 23 mit entlang der Tiefenerstreckung T konstanten Querschnittsabmessungen Q in vergrößerter Darstellung. Deutlich erkennbar sind eine Isolationsschicht 17, die erste elektrisch leitfähige Schicht 8, die zweite elektrisch leitfähige Schicht 9, die dazwischen angeordnete elektrische Isolationsschicht 14, eine an der Unterseite der zweiten elektrisch leitfähigen Schicht 9 angeordnete lichtleitende Schicht 10 und eine darunter angeordnete Trageschicht 18. Für die Verbindung mit dem ersten und zweiten elektrischen Stromversorgungsanschluss 11, 12 sind mit den elektrisch leitfähigen Schichten 8, 9 verbundene und voneinander isolierte elektrische Kontakte 25, 26 bis auf die Höhe der Isolationsschicht 17 nach oben geführt, sodass die Stromversorgungsanschlüsse 11, 12 auf die Kontakte 25, 26 aufgesetzt werden können.

Fig. 7 zeigt eine Ausnehmung 23, bei welcher in Richtung der Tiefenerstreckung T eine erste Querschnittsabmessung Q1 der Ausnehmung 23 in der ersten elektrisch leitfähigen Schicht 8 größer als eine zweite Querschnittsabmessung Q2 der Ausnehmung 23 in der elektrischen Isolationsschicht 14 ist und die zweite Querschnittsabmessung Q2 größer als eine dritte Querschnittsabmessung Q3 der Ausnehmung 23 in der zweiten elektrisch leitfähigen Schicht 9 ist. Zudem weist die Ausnehmung 23 entlang der Tiefenerstreckung T in der auf der ersten elektrisch leitfähigen Schicht 8 vorgesehenen zusätzlichen Isolationsschicht 17 eine vierte Querschnittsabmessung Q4 auf, welche größer als die erste Querschnittsabmessung Q1 der Ausnehmung 23 ist. Die Ausnehmung 23 weist somit entlang der Tiefenerstreckung T eine stufenweise Querschnittsreduktion auf, welche Kontaktflächen 27 der ersten und zweiten elektrisch leitfähigen Schicht 8, 9 und der lichtleitenden Schicht 10 freilegt. Die in Fig. 7 nicht dargestellte Ansteuereinheit 5 und somit auch der Bildkörper 7, kann daher einfach in die Ausnehmung 23 eingesetzt werden, wobei die Stromversorgungsanschlüsse 11, 12 und der lichterfassende Anschluss 13 auf die freigelegten Kontaktflächen 27 stromleitend und lichtleitend aufgesetzt werden.

Die Figuren 6 und 7 zeigen zudem Unebenheiten 28 der lichtleitenden Schicht 10, welche den Übergang der Lichtsignals LS von der lichtleitenden Schicht 10 in die lichterfassenden Anschlüsse 13 begünstigen.

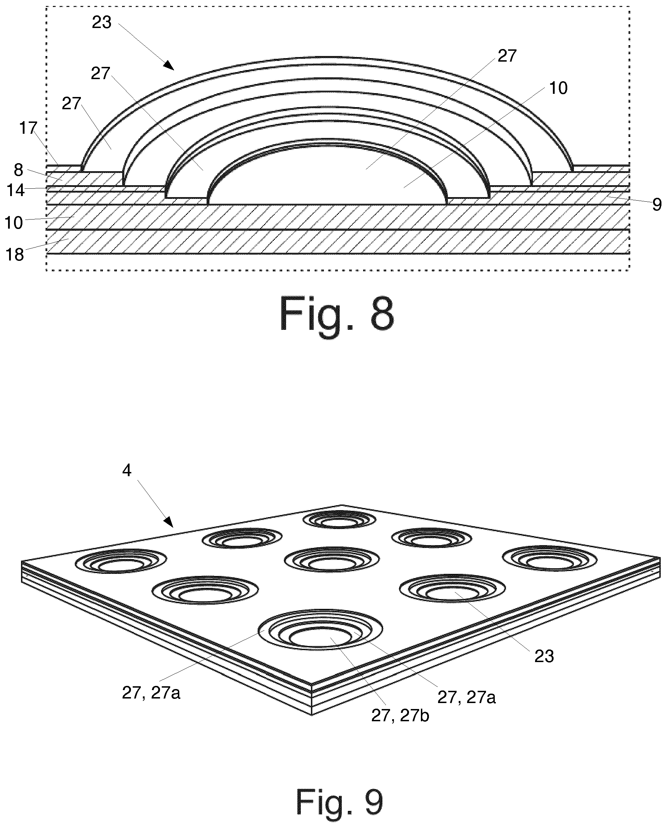

Fig. 8 zeigt eine Ausnehmung 23 mit stufenweiser Querschnittsreduktion, wobei im Unterschied zu den Figuren 6 und 7 die lichtleitende Schicht 10 frei von Unebenheiten 28 ist. Ein Übergang der Lichtsignale LS von der lichtleitenden Schicht 10 in die lichterfassenden Anschlüsse 13 ist dennoch gewährleistet, da auch ohne Unebenheiten 28 das Lichtsignal LS aus der lichtleitenden Schicht 10 austritt.

Fig. 9 zeigt einen Abschnitt eines Trägerkörpers 4 mit mehr als neun Ausnehmungen 23 oder einen nur neun Ausnehmungen 23 aufweisenden Trägerkörper 4. Wegen den stufenförmigen Ausnehmungen 23 sind die Kontaktflächen 27 freigelegt, auf welche die in Fig. 9 nicht dargestellten Stromversorgungsanschlüsse 11, 12 und lichterfassenden Anschlüsse 13 aufgesetzt werden können. Im Beispiel gemäß Fig. 9 sind ringförmige Kontaktflächen 27a für im Querschnitt vorzugsweise ringförmige Stromversorgungsanschlüsse 11, 12 und eine kreisförmige Kontaktfläche 27b für einen im Querschnitt vorzugsweise kreisförmigen lichterfassenden Anschluss 13 vorgesehen.

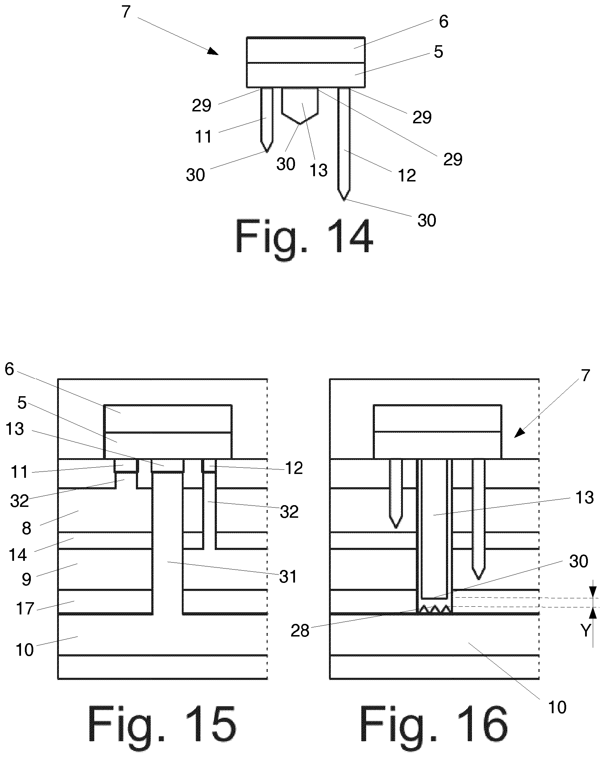

Fig. 14 zeigt einen Bildkörper 7, bei welchem die lichterfassenden Anschlüsse 13 und die ersten und zweiten elektrischen Stromversorgungsanschlüsse 11, 12 jeweils ein erstes Ende 29 aufweisen und mit dem ersten Ende 29 fest mit der Ansteuereinheit 5 verbunden sind.

Die Figuren 1, 2 und 3 zeigen einen Bildkörper 7, bei welchem die lichterfassenden Anschlüsse 13 und die ersten und zweiten elektrischen Stromversorgungsanschlüsse 11, 12 mit einem dem ersten Ende 29 gegenüberliegenden zweiten Ende 30 in die lichtleitende Schicht 10 und in die erste und zweite elektrisch leitfähige Schicht 8, 9 eingestochen sind.

Die Figuren 4, 5 und 15 zeigen einen Bildkörper 7, bei welchem die lichterfassenden Anschlüsse 13 und die ersten und zweiten elektrischen Stromversorgungsanschlüsse 11, 12 mit einem dem ersten Ende 29 gegenüberliegenden zweiten Ende 30 auf der lichtleitenden Schicht 10 und auf der ersten elektrisch leitfähigen Schicht 8 und auf der zweiten elektrisch leitfähigen Schicht 9 aufliegen.

Fig. 16 zeigt einen Bildkörper 7, bei welchem der lichterfassende Anschluss 13 mit dem zweiten Ende 30 in einem die Lichtleitung gewährleistenden Abstand Y zur lichtleitenden Schicht 10 angeordnet ist. Wenn die lichterfassenden Anschlüsse 13 mit dem zweiten Ende 30 auf der lichtleitenden Schicht 10 aufliegen oder in einem die Lichtleitung gewährleistenden Abstand Y zur lichtleitenden Schicht 10 angeordnet sind, kann die lichtleitende Schicht 10 an der Position der aufliegenden lichterfassenden Anschlüsse 13 oder an der Position einer gedachten Verlängerung der beabstandeten lichterfassenden Anschlüsse 13, so wie in Fig. 16 dargestellt, eine größere Unebenheit 28 als neben diesen Positionen aufweisen.

Die Figuren 1 bis 5 und 16 zeigen eine ebene Ausbildung der lichtleitenden Schicht 10 und der ersten und zweiten elektrisch leitfähigen Schicht 8, 9.

Fig. 15 zeigt beispielhaft einen Abschnitt einer Vorrichtung 1, bei welcher die lichtleitende Schicht 10, die erste elektrisch leitfähige Schicht 8 und die zweite elektrisch leitfähige Schicht 9 uneben ausgebildet sind, insbesondere mit lichtleitenden Erhöhungen 31 die den lichterfassenden Anschlüssen 13 zugewandt sind und mit elektrisch leitenden Erhöhungen 32 die den ersten und zweiten elektrischen Stromversorgungsanschlüssen 11, 12 zugewandt sind.

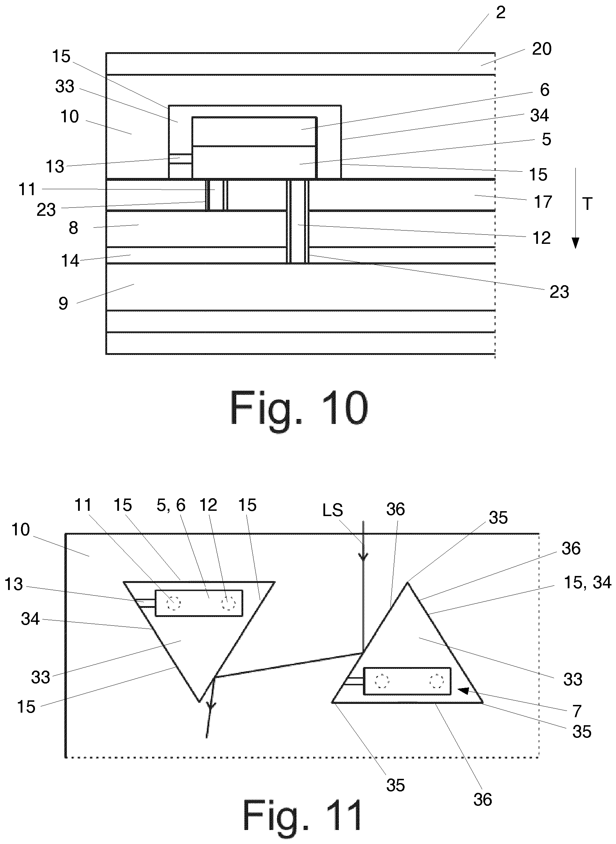

Fig. 10 zeigt beispielhaft eine Ansteuereinheit 5, die lichtleitend mit zumindest einer zwischen der Oberseite 2 und der ersten elektrisch leitfähigen Schicht 8 angeordneten lichtleitenden Schicht 10 verbunden ist. Die Ansteuereinheit 5 und im dargestellten Beispiel auch der Leuchtkörper 6 sind innerhalb einer Ansteuereinheit-Ausnehmung 33 angeordnet, welche in der zwischen der Oberseite 2 und der ersten elektrisch leitfähigen Schicht 8 angeordneten lichtleitenden Schicht 10 vorgesehen ist. Im dargestellten Beispiel ist die Ansteuereinheit-Ausnehmung 33 zudem von der lichtleitenden Schicht 10 bedeckt und somit in die lichtleitende Schicht 10 eingebettet. Die lichtleitende Schicht 10 kann daher unterhalb des Hauptkörpers der Ansteuereinheiten 5 oder auf einer gleichen Höhe wie die Bildkörper 7 oder auch über den Bildkörpern 7 angeordnet sein. Der lichterfassende Anschluss 13 kann in Tiefenrichtung T oder wie im dargestellten Beispiel parallel zur Oberseite 2 verlaufen und verbindet die Ansteuereinheit 5 mit der lichtleitenden Schicht 10. Die lichtleitende Schicht 10 weist im dargestellten Beispiel Begrenzungsränder 34 auf, welche die Ansteuereinheit-Ausnehmungen 33 umgeben und Streuflächen 15 aufweisen können.

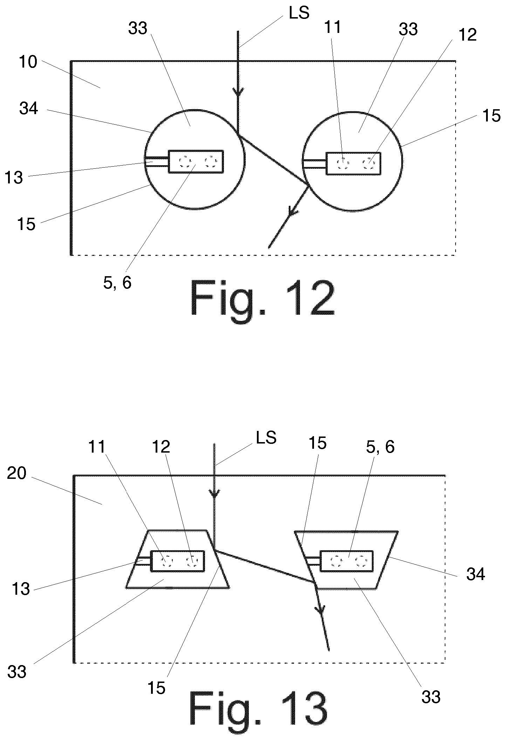

Die Figuren 11 bis 13 zeigen am Beispiel von zwei Ansteuereinheit-Ausnehmungen 33 Ausführungen von Begrenzungsrändern 34, welche ausgebildet sind, die Lichtsignale LS zwischen den Begrenzungsrändern 34 der unterschiedlichen Ansteuereinheit-Ausnehmungen 33 umzulenken. Auf diese Wiese werden Abschattungen durch die Bildkörper 7 vermieden oder zumindest reduziert. Im Beispiel gemäß Fig. 12 sind die Begrenzungsränder 34 rund ausgebildet. In den Beispielen gemäß den Figuren 11 und 13 sind die Begrenzungsränder 34 mit zumindest drei Ecken 35 und zwischen den Ecken 35 verlaufenden Randabschnitten 36 ausgebildet. Zumindest einander zugewandte Randabschnitte 36 benachbarter Ansteuereinheit-Ausnehmungen 33 können in unterschiedliche Richtungen orientiert sein, d.h. nicht-parallel zueinander ausgerichtet sein. Günstig ist es, wenn zwischen einem Einfallswinkel des Lichtsignals LS auf einen Abschnitt zumindest eines Begrenzungsrands 34 und dem selben Abschnitt des Begrenzungsrands 34 ein Winkel zwischen 10 Grad und 80 Grad, insbesondere zwischen 30 Grad und 60 Grad vorgesehen ist.

## Patentansprüche

1. Vorrichtung (1) zur Bilddarstellung aufweisend:
einen eine Oberseite (2) und eine Unterseite (3) aufweisenden Trägerkörper (4), welcher Ansteuereinheiten (5) und ansteuerbare Leuchtkörper (6) trägt, welche Leuchtkörper (6) näher zur Oberseite (2) als zur Unterseite (3) angeordnet sind, wobei jeweils eine Ansteuereinheit (5) mit zumindest einem Leuchtkörper (6) verbunden ist,
wobei der Trägerkörper (4) eine in einem ersten Abstand (X1) von der Oberseite (2) angeordnete erste elektrisch leitfähige Schicht (8), eine in einem zweiten Abstand (X2) von der Oberseite (2) angeordnete zweite elektrisch leitfähige Schicht (9) und zumindest eine lichtleitende Schicht (10) zur Leitung von Lichtsignalen (LS) aufweist,
wobei der zweite Abstand (X2) größer als der erste Abstand (X1) ist und die Ansteuereinheiten (5) zur Ansteuerung der damit verbundenen Leuchtkörper (6) in Abhängigkeit von in die lichtleitende Schicht (10) eingespeisten Lichtsignalen (LS) ausgebildet sind,
wobei die Ansteuereinheiten (5) über erste elektrische Stromversorgungsanschlüsse (11) mit der ersten elektrisch leitfähigen Schicht (8), über zweite elektrische Stromversorgungsanschlüsse (12) mit der zweiten elektrisch leitfähigen Schicht (9) und über lichterfassende Anschlüsse (13) lichtleitend mit der lichtleitenden Schicht (10) verbunden sind,
**dadurch gekennzeichnet, dass**
zwischen der ersten elektrisch leitfähigen Schicht (8) und der zweiten elektrisch leitfähigen Schicht (9) eine elektrische Isolationsschicht (14) vorgesehen ist und die zumindest eine lichtleitende Schicht (10) zwischen der Oberseite (2) und der ersten elektrisch leitfähigen Schicht (8) angeordnet ist, in welcher lichtleitenden Schicht (10) Streuflächen (15) angeordnet sind, und/oder die zumindest eine lichtleitende Schicht (10) zwischen der zweiten elektrisch leitfähigen Schicht (9) und der Unterseite (3) angeordnet ist.

2. Vorrichtung (1) nach Anspruch 1, **dadurch gekennzeichnet, dass** sich zumindest Teilabschnitte der lichterfassenden Anschlüsse (13) und/oder der ersten elektrischen Stromversorgungsanschlüsse (11) und/oder der zweiten elektrischen Stromversorgungsanschlüsse (12) in Ausnehmungen (23) im Trägerkörper (4) erstrecken.

3. Vorrichtung (1) nach Anspruch 2, **dadurch gekennzeichnet, dass** die Ausnehmungen (23) eine Tiefenerstreckung (T) aufweisen, entlang welcher Querschnittsabmessungen (Q) der Ausnehmungen (23) konstant sind.

4. Vorrichtung (1) nach Anspruch 2, **dadurch gekennzeichnet, dass** die Ausnehmungen (23) eine Tiefenerstreckung (T) aufweisen, entlang welcher eine erste Querschnittsabmessung (Q1) der Ausnehmung (23) in der ersten elektrisch leitfähigen Schicht (8) größer als eine zweite Querschnittsabmessung (Q2) der Ausnehmung (23) in der elektrischen Isolationsschicht (14) ist und diese größer als eine dritte Querschnittsabmessung (Q3) der Ausnehmung (23) in der zweiten elektrisch leitfähigen Schicht (9) ist.

5. Vorrichtung (1) nach einem der Ansprüche 2 bis 4, **dadurch gekennzeichnet, dass** die Streuflächen (15) an den ersten und/oder zweiten elektrischen Stromversorgungsanschlüssen (11, 12) und/ oder an Wänden (24) der Ausnehmungen (23) vorgesehen sind.

6. Vorrichtung (1) nach einem der Ansprüche 1 bis 5, **dadurch gekennzeichnet, dass** zumindest eine Ansteuereinheit (5) jener Ansteuereinheiten (5), die lichtleitend mit der zwischen der Oberseite (2) und der ersten elektrisch leitfähigen Schicht (8) angeordneten lichtleitenden Schicht (10) verbunden sind, innerhalb einer Ansteuereinheit-Ausnehmung (33) angeordnet ist, welche in der zwischen der Oberseite (2) und der ersten elektrisch leitfähigen Schicht (8) angeordneten lichtleitenden Schicht (10) vorgesehen ist.

7. Vorrichtung (1) nach Anspruch 6, **dadurch gekennzeichnet, dass** die Ansteuereinheit-Ausnehmungen (33) umgebende Begrenzungsränder (34) der lichtleitenden Schicht (10) die Streuflächen (15) aufweisen und insbesondere die Begrenzungsränder (34) von zumindest zwei Ansteuereinheit-Ausnehmungen (33), vorzugsweise von zumindest der Hälfte der Ansteuereinheit-Ausnehmungen (33), angeordnet sind, die Lichtsignale (LS) zwischen den Begrenzungsrändern (34) umzulenken.

8. Vorrichtung (1) nach Anspruch 7, **dadurch gekennzeichnet, dass** die Begrenzungsränder (34) rund ausgebildet sind und/oder die Begrenzungsränder (34) mit zumindest drei Ecken (35) und zwischen den Ecken (35) verlaufenden Randabschnitten (36) ausgebildet sind, wobei insbesondere einander zugewandte Randabschnitte (36) benachbarter Ansteuereinheit-Ausnehmungen (33) unterschiedlich orientiert sind.

9. Vorrichtung (1) nach einem der Ansprüche 1 bis 8, **dadurch gekennzeichnet, dass** die lichtleitende Schicht (10) und/oder die erste elektrisch leitfähige Schicht (8) und/oder die zweite elektrisch leitfähige Schicht (9) eben ausgebildet ist oder uneben mit den lichterfassenden Anschlüssen (13) zugewandten lichtleitenden Erhöhungen (31) und/oder den ersten elektrischen Stromversorgungsanschlüssen (11) zugewandten elektrisch leitenden Erhöhungen (32) und/oder den zweiten elektrischen Stromversorgungsanschlüssen (12) zugewandten elektrisch leitenden Erhöhungen (32) ausgebildet ist.

10. Vorrichtung (1) nach einem der Ansprüche 1 bis 9, **dadurch gekennzeichnet, dass** die lichterfassenden Anschlüsse (13) mit einem ersten Ende (29) fest mit den Ansteuereinheiten (5) verbunden sind und mit einem dem ersten Ende (29) gegenüberliegenden zweiten Ende (30) in die lichtleitende Schicht (10) eingestochen sind oder auf der lichtleitenden Schicht (10) aufliegen oder in einem die Lichtleitung gewährleistenden Abstand (Y) zur lichtleitenden Schicht (10) angeordnet sind.

11. Vorrichtung (1) nach einem der Ansprüche 1 bis 10, **dadurch gekennzeichnet, dass** die lichterfassenden Anschlüsse (13) mit einem ersten Ende (29) fest mit den Ansteuereinheiten (5) verbunden sind und mit einem dem ersten Ende (29) gegenüberliegenden zweiten Ende (30) entweder auf der lichtleitenden Schicht (10) aufliegen oder in einem die Lichtleitung gewährleistenden Abstand (Y) zur lichtleitenden Schicht (10) angeordnet sind, wobei die lichtleitende Schicht (10) an der Position der aufliegenden lichterfassenden Anschlüsse (13) oder an der Position einer gedachten Verlängerung der beabstandeten lichterfassenden Anschlüsse (13) eine größere Unebenheit (28) als neben diesen Positionen aufweist.

12. Vorrichtung (1) nach einem der Ansprüche 1 bis 11, **dadurch gekennzeichnet, dass** die ersten und/oder zweiten elektrischen Stromversorgungsanschlüsse (11, 12) mit einem ersten Ende (29) fest mit der Ansteuereinheit (5) verbunden sind und mit einem dem ersten Ende (29) gegenüberliegenden zweiten Ende (30) in die erste elektrisch leitfähige Schicht (8) und/oder in die zweite elektrisch leitfähige Schicht (9) eingestochen sind oder darauf aufliegen.

13. Vorrichtung (1) nach einem der Ansprüche 1 bis 12, **dadurch gekennzeichnet, dass** alle Schichten des Trägerkörpers (4) aus lichtdurchlässigem Material gebildet sind.

14. Vorrichtung (1) nach einem der Ansprüche 1 bis 13, **dadurch gekennzeichnet, dass** die Leuchtkörper (5) Leuchtdioden oder elektrisch verformbare und Umgebungslicht brechende Kristalle sind.
